# EUROPÄISCHE PATENTSCHRIFT

(11) **EP 0 812 126 B1**
(45) Veröffentlichungstag und Bekanntmachung des Hinweises auf die Patenterteilung: **08.08.2001**
(21) Anmeldenummer: 97108256.5
(22) Anmeldetag: 22.05.1997
(51) Int. Cl.: H05K 5/02

(54) **Verfahren zum Verbinden der Teile eines mehrteiligen Metallgehäuses durch Verkleben**
Method for bonding several parts of a metallic casing by glueing
Procédé pour lier par collage les parties multiples d'un boîtier métallique

(30) Priorität: 07.06.1996 DE 19622817
(43) Veröffentlichungstag der Anmeldung: 10.12.1997
(73) Patentinhaber: Diehl Stiftung & Co., 90478 Nürnberg (DE)
(72) Erfinder: Dauben Peter, Dr., 90518 Altdorf (DE); Kaspar, Stefan, 91227 Leinburg (DE)
(74) Vertreter: Hofmann, Gerhard, Dipl.-Ing. Patentassessor

(56) Entgegenhaltungen:
- US-A- 4 762 983
- US-A- 5 208 732
- US-A- 5 475 919
- US-A- 5 574 628
- DATABASE WPI Section Ch, Week 9046 Derwent Publications Ltd., London, GB; Class A17, AN 90-344052 XP002081665 & JP 02 247275 A (SHINKO KAGAKU KOGYO KK) , 3. Oktober 1990
- DATABASE WPI Section Ch, Week 8418 Derwent Publications Ltd., London, GB; Class A18, AN 84-111238 XP002081666 & JP 59 051965 A (NITTO ELECTRIC IND CO) , 26. März 1984

## Beschreibung

Die Erfindung betrifft ein Verfahren zum Verbinden der Teile eines mehrteiligen Metallgehäuses durch Verkleben, insbesondere eines Metallgehäuses für PCMCIA-Karten, wobei das Gehäuse aus einem Rahmen und mindestens einem Deckel besteht.

Derartige Gehäuse sind bekannt und als Kunststoffgehäuse bereits seit Jahren auf dem Markt. Neuerdings werden solche Gehäuse aus Metall und insbesondere aus Kupferlegierungen gefertigt. Bei Metallgehäusen ist es üblich, die Gehäuseteile miteinander zu verschweißen, insbesondere vermittels eines Lasers. Es sind auch Versuche unternommen worden, derartige Gehäuse zu verlöten. Nachdem die Gehäuse eine Buchsenleiste mit üblicherweise 68 Anschlüssen aufweisen und diese Buchsenleiste aus Isolationsgründen nicht aus Metall sein kann, ist der Aufwand in der Präparierung der Oberfläche der Buchsenleiste, um sie dann verlöten zu können, relativ hoch.

Aus der OS 5 208 732 A1 ist es bereits bekannt, bei einer Speicherkarte den Deckel und das Rahmenteil mit einer Klebstoffschicht zu versehen, um Deckel und Rahmenteil miteinander zu verbinden.
Aus der OS 4 762 983 A1 ist es ferner bekannt, die Struktur eines dünnen elektronischen Rechners durch Einlegen von Klebebändern als Zwischenschichten zwischen den Leiterkarten und den vorderen und hinteren Außendeckel miteinander durch Pressen bei etwa 100° bis 180° C zu verbinden.
Dem gegenüber ist es Aufgabe der Erfindung, ein Verfahren anzugeben, bei welchem eine Verbindung zwischen Deckel und Rahmenteil einer die Gehäuseteile einer PCM-CIA-Karte maschinell in einfacher und kostengünstiger Weise bei sehr guter Dichtigkeit hergestellt werden kann.
Zur Lösung dieser Aufgabe schlägt die Erfindung das im Anspruch 1 gekennzeichnete Verfahren vor.
Eine besonders zweckmäßige Anwendung des Verfahrens ergibt es sich bei Verwendung von zwei Deckeln zur Verschließung des Rahmens an der Ober- und Unterseite der Karte.

Der Grundgedanke der Erfindung besteht darin, daß der bzw. die Deckel auf ihrer Gehäuseinnenseite vorbereitend mit einer beidseitig klebenden Klebstoff-Folie versehen werden, diese Deckel auf den Rahmen gelegt werden und in einer Presse unter Druck und Temperatur miteinander verklebt werden.

Diese Klebeverfahren hat gegenüber dem Verschweißen oder Verlöten nicht nur deutliche Vorteile in den Herstellkosten, es hat auch die nachstehend aufgeführten Vorzüge.
Die Temperaturbelastung der Elektronikteile bei dem Verschließvorgang des Gehäuses ist geringer als bei dem Verschweißen oder Verlöten. Dadurch ergibt sich eine geringere Ausfallrate der Elektronik.
Durch das Verkleben sind die vom Gehäuse annehmbaren und ohne Beschädigung ertragbaren mechanischen Belastungen wie z. B. Drehmomente und Biegemomente aufgrund der Elastizität der Klebefolie höher als bei verschweißten oder verlöteten Gehäusen.
Der Klebstoff wird bei der Arbeitstemperatur in der Presse nicht flüssig und tritt damit nicht aus dem Klebespalt aus. Das Gehäuse muß daher nicht wie beim Verlöten, nachgearbeitet werden. Neben diesem Vorteil bezüglich der Herstellkosten ergeben sich weitere auch Vorteile wegen der nicht notwendigen oberflächentechnischen Vorbehandlung und durch das Fehlen teuerer Spezialeinrichtungen, wie beim Verschweißen notwendig, sowie geringerer Umwelt- und Entsorgungsprobleme.

Trotz dieser Vorteile können Verbindungen mit hoher Dichtigkeit, (<10⁻⁶ mbar l/s), erzielt werden einschließlich einer ausreichenden Leitfähigkeit der Verbindung um eine hohe EMV-Sicherheit zu erreichen.

Das Aufbringen der Klebstoff-Folie auf die Deckel kann gemäß einer Weiterbildung der Erfindung in günstiger Weise dadurch vorgenommen werden, daß auf einem Metallband, vorzugsweise einem Kupferband, im Durchlauf eine beidseitig klebende Klebstoff-Folie, die auf der dem Metallband abgewandten Seite ein Trennpapier trägt, durch Einwirkung von Wärme und geringem Druck aufgeklebt wird, daß anschließend die Deckel in der passenden Größe ausgestanzt werden und dann das Trennpapier abgezogen wird.

Je nach Ausführungsform dieser Deckel ist gemäß einer Weiterbildung der Erfindung vorgesehen, daß vor dem Ausstanzen die Deckel tiefgezogen werden.

Die Klebstoff-Folie wird vorzugsweise bei einer Temperatur von etwa 120°C auf das Metallband bei geringem Druck und einer Durchlaufgeschwindigkeit von etwa 1 Meter/min aufgeklebt.

Die Erfindung ist weiterhin vorteilhaft dadurch ausgebildet, daß nach Einlegen der zu verbindenden Gehäuseteile (Deckel, Rahmen) in das Presswerkzeug ein Druck von etwa 0,5 - 2 N/mm², vorzugsweise 1 N/mm², auf die Gehäuseteile im Bereich des Rahmens aufgebracht und dann auf eine Temperatur von etwa 120°C bis 180°C aufgeheizt wird.

Um die Elektronikteile im Gehäuse gegen Hitzeeinwirkung möglichst zu schützen, ist in weiterer Ausgestaltung der Erfindung vorgesehen, daß während der Aufbringung von Druck und Temperatur im Bereich des Rahmens, das Mittelteil des/der Deckel gekühlt wird. Dabei kann die Temperaturdifferenz am Deckel zwischen dem aufgeheizten Bereich am Rahmen und dem gekühlten Mittelteil bis zu 100°C betragen.

Nachfolgend soll das erfindungsgemäße Verfahren unter Hinweis auf die Zeichnungen noch näher erläutert werden. Es zeigen:
- Fig. 1: ein verschlossenes Gehäuse;
- Fig. 2: ein Deckel in Draufsicht;
- Fig. 3: ein Deckel im Schnitt entlang der Linie A-A von Fig. 2;
- Fig. 4: ein Rahmen;
- Fig. 5: eine Leiterkarte, schematisch dargestellt mit daran angeordneter Buchsenleiste;
- Fig. 6: eine schematische Darstellung des Verklebens von Metallband und Klebstoff-Folie.

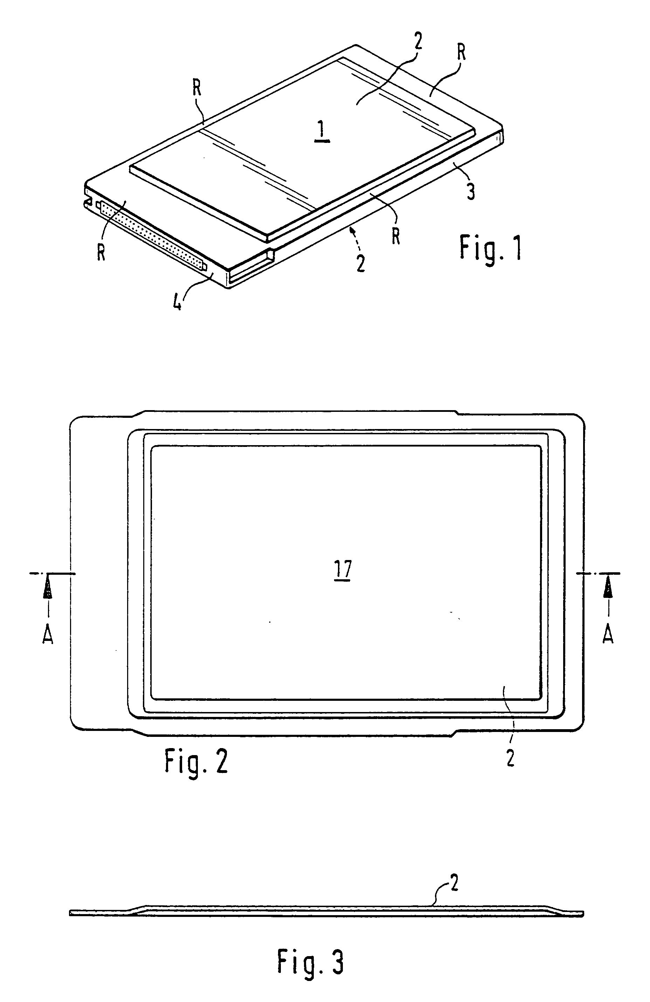

In Figur 1 ist ein fertiges PCMCIA-Gehäuse 1 dargestellt, dessen Oberseite und Unterseite durch je einen Deckel 2, dessen Seitenkanten durch einen Rahmen 3 und dessen linke Schmalseite durch eine Buchsenleiste 4 gebildet sind. Die Buchsenleiste enthält 68 Buchsenanschlüsse, mit denen das Gehäuse auf entsprechende Steckeranschlüsse in einem Rechner aufgeschoben wird. An den mit R gekennzeichneten Stellen im Bereich des Rahmens des Gehäuses 1 wird während des Verklebungsprozesses Temperatur und Druck durch das Preßwerkzeug ausgeübt.

In den Figuren 2 und 3 ist ein Deckel in Draufsicht und im Schnitt - hier noch ohne Klebstoff-Folie - dargestellt. Dieser Deckel ist vorzugsweise aus einer Kupferlegierung CuNi9Sn2 gefertigt. Von diesen Deckeln werden zwei zum Verschließen des Gehäuses benötigt. An der Gehäuseinnenseite der Deckel wird, hier nicht dargestellt, die Klebstoff-Folie aufgebracht. Sie erstreckt sich über die gesamte Fläche der Deckel und bleibt auch nach deren Tiefziehen aufgrund ihrer Elastizität voll erhalten.

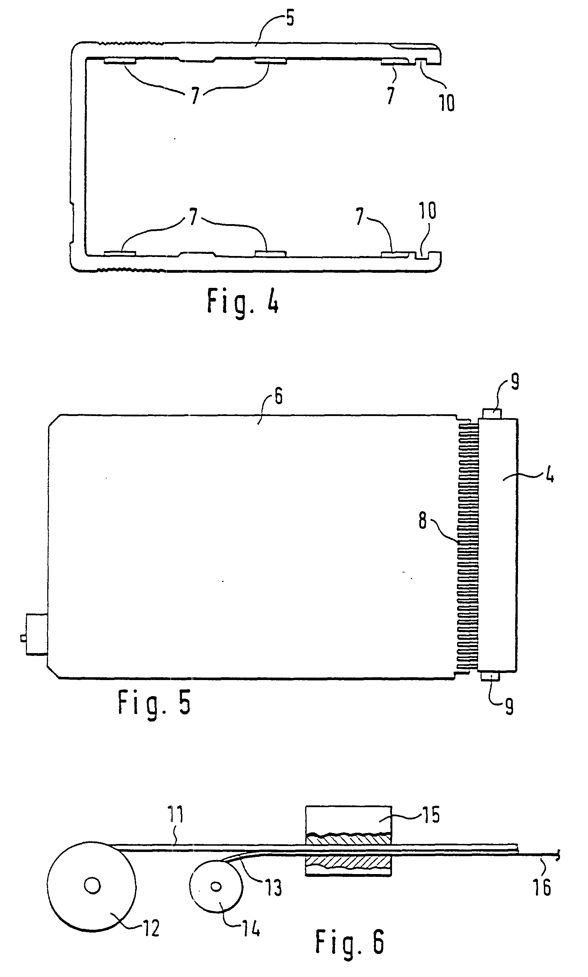

In Figur 4 ist der Metallrahmen 5 dargestellt, in den eine Leiterkarte 6 gemäß Figur 5 auf den Vorsprüngen 7 eingeklebt wird. Auf dieser Leiterkarte, bei welcher der Übersichtlichkeit halber die Leiterbahnen und die darauf bestückten Elektronikbauteile nicht dargestellt sind, ist die Buchsenleiste 4 mit ihren gehäuseinneren Anschlußfahnen 8 dargestellt. Diese Buchsenleiste 4 enthält an den Seiten Nasen 9, welche in die entsprechenden Nuten 10 des Rahmens 5 eingreifen und diese verschließen. Durch diese Nasen 9 wird die Buchsenleiste im Rahmen besonders geführt und erhält eine ausreichende Festigkeit.

Zur Vorbereitung des erfindungsgemäßen Verfahrens wird gemäß Figur 6 ein Metallband 11, welches auf einer Trommel 12 aufgewickelt ist, zusammen mit einer Klebstoff-Folie 13, welche ebenfalls auf einer Trommel 14 aufgewickelt ist einer Durchlaufpresse 15 zugeführt, in welcher bei einer Temperatur von etwa 120 °C und geringem Druck ein Verkleben von Metallband 11 und Klebstoff-Folie 13 erfolgt. Auf der Klebstoff-Folie ist ein Trennpapier 16 zum Schutze der zweiten klebenden Seite aufgebracht. In einer nicht dargestellten Stanzeinrichtung werden nacheinander Deckel 2 tiefgezogen und anschließend ausgestanzt, wie man dies aus der Darstellung nach Figur 3 erkennt. Aufgrund der Elastizität der Klebstoff-Folie wird diese beim Tiefziehen und Stanzen nicht beschädigt. Ehe die Deckel 2 in eine Presse eingelegt werden, wird das Trennpapier 16 abgezogen. Die Deckel werden in der Presse an der Ober- und Unterseite des Rahmens 5 aufgelegt. Im Rahmen 5 ist bereits eine Leiterkarte mit elektronischen Bausteinen und einer angelöteten Buchsenleiste 4 an den Auflagepunkten 7 eingeklebt. Durch die Deckel 2 an Ober-und Unterseite wird das Gehäuse vollständig.

Nunmehr wird im Presswerkzeug der Stempel abgesenkt und ein Druck von 1 N/mm² aufgebaut. Anschließend wird eine im Presswerkzeug angeordnete Induktionsspule aufgeheizt und erzeugt an den Auflagepunkten am Presswerkzeug eine Temperatur von etwa 160 °C. Die Auflagepunkte des Presswerkzeugs an dem Gehäuse sind in Figur 1 mit R bezeichnet. Man erkennt, daß die Deckel 2 nur an ihren Auflagestellen am Rahmen beheizt werden. Nur dort wird der Klebstoff heiß und härtet unter voller Wirkung seiner Klebfähigkeit aus. Damit sind die drei Gehäuseteile sowie die Buchsenleiste 4 miteinander verklebt.

Eine Klebstoff-Folie, wie sie z. B. unter dem Warennamen Tesa 8410 (Tesa ist ein eingetragenes Warenzeichen) auf dem Markt ist, trägt als Klebmasse Nitrilkautschuk/Phenolharz mit einer Klebfestigkeit >10N/mm². Diese Klebmasse ermöglicht eine hohe Dichtigkeit des verklebten Gehäuses, welche eine Leckrate größer 10⁻⁶ l/s erreichen kann. Damit werden auch hohe Industrieanforderungen an die Dichtigkeit solcher Gehäuse erfüllt. Aufgrund der Kontur der gestanzten Deckel und des Rahmens stellt sich unter den beschriebenen Herstellbedingungen eine leitfähige Verbindung zwischen den Einzelteilen ein, mit Übergangswiderständen im Milliohmbereich, so daß eine gute EMV-Sicherheit des Innenraums der PC-Karte gewährleistet ist.

Nachdem das Gehäuse mehrere Minuten in dem Presswerkzeug bei der angegebenen Temperatur eingelegt war, wobei der Mittelteil 17 der Deckel von oben und unten auf eine Temperatur von etwa 80° - 90 °C abgekühlt wurde, wird unter Aufrechterhaltung des Drucks die Heizung abgeschaltet, das Gehäuse auf eine Entnahmetemperatur abgekühlt und dann entnommen.

Die Gehäuse sind damit fertig, eine Nacharbeit entfällt. Aufgrund der Verklebung ist es möglich, wenn bei der Elektronik Fehler auftreten, sei es unmittelbar nach der Fertigung oder sei es auch erst zu einem späteren Zeitpunkt, die Klebung wieder zu öffnen, eine Reparatur vorzunehmen und wieder neu zu verkleben. Derartige einfache Reparaturmöglichkeiten ergeben sich bei verlöteten oder gar verschweißten Gehäusen nicht.

## Patentansprüche

1. Verfahren zum Verbinden der Teile eines mehrteiligen Metallgehäuses durch Verkleben, insbesondere eines Metallgehäuses für PCMCIA-Karten, wobei das Gehäuse aus einem Rahmen und mindestens einem Deckel besteht, wobei ferner der Deckel (2) an seiner Gehäuseinnenseite mit Klebstoff versehen wird, dann in einem Presswerkzeug auf den Rahmen (5), welcher, vormontiert eine Leiterkarte (6) mit Elektronikbausteinen und einer Buchsenleiste (4) trägt, aufgelegt und unter Druck und einer Temperatur von etwa 120° - 180 °C verpreßt wird,
dadurch gekennzeichnet,
daß auf einem Metallband (11) vorzugsweise einem Kupferband, im Durchlauf eine beidseitig klebende Klebstoff-Folie (13), die auf der dem Metallband abgewandten Seite ein Trennpapier (16) trägt, durch Einwirkung von Wärme und geringem Druck auf das Metallband aufgeklebt wird, daß anschließend der/die Deckel (2) in der passenden Größe aus dem mit Klebstoff-Folie (13) versehenen Metallband ausgestanzt werden, und dann das Trennpapier (16) abgezogen wird.

2. Verfahren nach Anspruch 1,
dadurch gekennzeichnet,
daß zwei, vorzugsweise identische, Deckel (2) verwendet sind, die von oben und unten auf den Rahmen (5) aufgelegt werden.

3. Verfahren nach Anspruch 1,
dadurch gekennzeichnet,
daß vor dem Ausstanzen die Deckel (2) tiefgezogen werden.

4. Verfahren nach Anspruch 1,
dadurch gekennzeichnet,
daß die Klebstoff-Folie (13) bei einer Temperatur von etwa 120°C auf das Metallband (11) bei geringem Druck und einer Durchlaufgeschwindigkeit von etwa 1 m/min. aufgeklebt wird.

5. Verfahren nach einem oder mehreren derAnsprüche 1 bis 4,
dadurch gekennzeichnet,
daß nach Einlegen der zu verbindenden Gehäuseteile (Deckel, Rahmen) (2, 5) in das Presswerkzeug ein Druck von 0,5 - 2 N/mm², vorzugsweise 1 N/mm², auf die Gehäuseteile im Bereich (R) des Rahmens aufgebracht und dann auf eine Temperatur von etwa 120° - 180 °C aufgeheizt wird.

6. Verfahren nach einem oder mehreren der Ansprüche 1 bis 5,
dadurch gekennzeichnet,
daß während der Aufbringung von Druck und Temperatur im Bereich R des Rahmens das Mittelteil (17) des/der Deckel (2) zum Schutz der Elektronikteile im Gehäuse gekühlt wird.

7. Verfahren nach Anspruch 6,
dadurch gekennzeichnet,
daß die Temperaturdifferenz am Deckel zwischen dem aufgeheizten Bereich (R) am Rahmen und dem gekühlten Mittelteil (17) bis zu 100 °C beträgt.

## Claims

1. Method of connecting the parts of a multi-part metal housing by gluing, in particular a metal housing for PCMCIA cards, the housing consisting of a frame and at least one cover, in which case the cover (2) is further provided with an adhesive substance on its side facing the interior of the housing, then it is placed in a pressing tool on the frame (5), which, as a pre-assembled unit carries a printed card (6) with electronic components and a socket terminal strip (4), and the cover is put under pressure at a temperature of approx. 120°C - 180°C,
characterized in that
on a metal strip (11) preferably a copper strip, a double-sided adhesive film (13), which carries a release paper (16) on the side facing *away* from the metal strip, is continuously applied on to the metal strip under the influence of heat and slight pressure; in that then the cover or covers (2) are punched out in the appropriate size from said metal strip provided with adhesive film (13) and the release paper (16) is then drawn off.

2. Method according to Claim 1,
characterized in that
two, preferably identical, covers (2) are used, which are placed on the frame (5) from above and from below.

3. Method according to Claim 1,
characterized in that
the covers (2) are deep-drawn prior to the punching-out stage.

4. Method according to Claim 1,
characterized in that
the adhesive film (13) is applied on to the metal strip (11) at a temperature of approx. 120°C with a slight pressure and a running speed of approx. 1 m/min.

5. Method according to one or more of Claims 1 to 4,
characterized in that,
after insertion of the housing components (covers, frame) (2, 5) to be connected into the pressing tool, a pressure of 0.5 - 2 N/mm², preferably 1 N/mm², is applied on to the housing components in the region (R) of the frame and it is then heated to a temperature of approx. 120°C - 180°C.

6. Method according to one or more of Claims 1 to 5,
characterized in that,
during the application of pressure and temperature in the region (R) of the frame, the central portion (17) of the cover or covers (2) is cooled to protect the electronic components in the housing.

7. Method according to Claim 6,
characterized in that
the temperature difference on the cover between the heated region (R) near the frame and the cooled central portion (17) amounts to up to 100°C.

## Revendications

1. Procédé de liaison par collage des parties d'un boîtier métallique en plusieurs parties, notamment d'un boîtier métallique pour cartes PCMCIA, le boîtier étant constitué d'un cadre et d'au moins un couvercle, le couvercle (2) étant en outre pourvu de colle sur sa face intérieure au boîtier, puis étant placé dans un outil de compression sur le cadre (5), lequel, prémonté, porte une carte à circuits imprimés (6) avec des composants électroniques et une barrette de douilles (4), et est soumis à une pression et à une température d'environ 120° à 180 °C, caractérisé en ce que sur une bande métallique (11), de préférence une bande de cuivre, une feuille adhésive (13), adhésive sur ses deux faces, et qui porte un papier de séparation (16) sur sa face tournée à l'opposé de la bande métallique, est collée en continu sur la bande métallique par action de la chaleur et d'une pression réduite, en ce qu'ensuite, le/les couvercle(s) (2) est(sont) découpé(s) à la matrice dans la taille adaptée, dans la bande métallique pourvue de la feuille adhésive (13), et le papier de séparation (16) est ensuite enlevé.

2. Procédé selon la revendication 1, caractérisé en ce qu'on utilise deux couvercles (2), de préférence identiques, qui sont placés sur le cadre (5), à partir du haut et du bas.

3. Procédé selon la revendication 1, caractérisé en ce que les couvercles (2) sont soumis à un emboutissage profond avant d'être découpés à la matrice.

4. Procédé selon la revendication 1, caractérisé en ce que la feuille adhésive (13) est collée sur la bande métallique (11), à une température d'environ 120 °C, sous une pression réduite et à une vitesse de défilement d'environ 1 m/mn.

5. Procédé selon une ou plusieurs des revendications 1 à 4, caractérisé en ce qu'après mise en place des parties de boîtier (couvercle, cadre) (2, 5) à assembler, dans l'outil de compression, on applique une pression de 0,5 à 2 N/mm², de préférence de 1 N/mm², sur les parties du boîtier, dans la zone R du cadre, et on chauffe ensuite à une température d'environ 120 °C à 180 °C.

6. Procédé selon une ou plusieurs des revendications 1 à 5, caractérisé en ce que pendant l'application de la pression et de la température dans la zone R du cadre, la partie centrale (17) du/des couvercle(s) (2) est refroidie pour protéger les composants électroniques du boîtier.

7. Procédé selon la revendication 6, caractérisé en ce que la différence de température du couvercle, entre la zone chauffée R du cadre et la partie centrale refroidie (17), atteint jusqu'à 100 °C.
